(19) Europäisches Patentamt
European Patent Office
Office européen des brevets

(11) EP 1 530 238 B1

(12) FASCICULE DE BREVET EUROPEEN

(45) Date de publication et mention de la délivrance du brevet:
**15.10.2008 Bulletin 2008/42**

(51) Int Cl.:
***H01L 27/144*** (2006.01) ***H01L 27/146*** (2006.01)

(21) Numéro de dépôt: **04300759.0**

(22) Date de dépôt: **04.11.2004**

# (54) Dispositif de détection de rayonnements infrarouges à détecteurs bolométriques

Bolometrische Detektorvorrichtung für infrarote Strahlung

Bolometric detecting device for infrared radiation

(84) Etats contractants désignés:
**DE FR GB IT SE**

(30) Priorité: **10.11.2003 FR 0313181**

(43) Date de publication de la demande:
**11.05.2005 Bulletin 2005/19**

(73) Titulaire: **ULIS**
**38113 Veurey Voroize (FR)**

(72) Inventeur: **Vilain, M. Michel**
**38450, Saint Georges de Commiers (FR)**

(74) Mandataire: **Vuillermoz, Bruno et al**
**Cabinet Laurent & Charras**
**"Le Contemporain"**
**50, Chemin de la Bruyère**
**69574 Dardilly Cédex (FR)**

(56) Documents cités:
**EP-A- 0 721 226**
**GB-A- 2 200 246**
**US-A- 5 554 849**
**US-A- 6 064 066**
**US-A- 6 080 987**
**US-A- 6 157 404**
**US-B1- 6 441 413**

Il est rappelé que: Dans un délai de neuf mois à compter de la publication de la mention de la délivrance du brevet européen au Bulletin européen des brevets, toute personne peut faire opposition à ce brevet auprès de l'Office européen des brevets, conformément au règlement d'exécution. L'opposition n'est réputée formée qu'après le paiement de la taxe d'opposition. (Art. 99(1) Convention sur le brevet européen).

EP 1 530 238 B1

Printed by Jouve, 75001 PARIS (FR)

## Description

## DOMAINE TECHNIQUE

La présente invention concerne un dispositif de détection de rayonnements infrarouges mettant en oeuvre des détecteurs bolométriques. L'invention trouve notamment son domaine d'application dans l'imagerie infrarouge.

## ARRIERE-PLAN TECHNOLOGIQUE

Dans le domaine des détecteurs infrarouges, il est connu d'utiliser des dispositifs agencés sous forme matricielle, et susceptibles de fonctionner à la température ambiante, c'est à dire ne nécessitant pas de refroidissement à de très basses températures, contrairement aux dispositifs de détection appelés détecteurs quantiques, qui eux nécessitent un fonctionnement à très basse température, typiquement celle de l'azote liquide.

Ces détecteurs non refroidis utilisent traditionnellement la variation d'une grandeur physique d'un matériau approprié, en fonction de la température au voisinage de 300 K. Dans le cas des détecteurs bolométriques, cette grandeur physique est la résistivité électrique.

Un tel détecteur non refroidi associe généralement :

- des moyens d'absorption du rayonnement infrarouge et de conversion de ce dernier en chaleur ;
- des moyens d'isolation thermique du détecteur, de telle sorte à permettre à celui-ci de s'échauffer sous l'action du rayonnement infrarouge ;
- des moyens de thermométrie, qui dans le cadre d'un détecteur bolométrique mettent en oeuvre un élément résistif ;
- et des moyens de lecture des signaux électriques fournis par les moyens de thermométrie.

Les détecteurs destinés à l'imagerie infrarouge sont réalisés sous la forme d'une matrice de détecteurs élémentaires selon une ou deux dimensions, sur un substrat, généralement réalisé en silicium, qui comporte des moyens d'excitation électrique desdits détecteurs élémentaires, et des moyens de pré-traitement des signaux électriques générés par ces détecteurs élémentaires.

Ces moyens d'excitation électrique et de pré-traitement sont formés sur le substrat et constituent un circuit de lecture.

L'intégration monolithique des détecteurs au circuit de lecture correspondant est avantageuse du point de vue des coûts de fabrication. Toutefois, il est également possible d'hybrider une matrice de détecteurs sur un tel circuit de lecture.

Un dispositif comportant une matrice de détecteurs élémentaires et un circuit de lecture associé est généralement placé dans un boîtier et est relié, notamment électriquement, au milieu extérieur par des techniques classiques. Dans un tel boîtier, la pression est réduite afin de limiter les pertes thermiques. Ce boîtier est en outre muni d'une fenêtre infrarouge transparente au rayonnement à détecter.

Le document US 6,064,066 décrit un détecteur bolométrique avec autocalibration.

Pour observer une scène par l'intermédiaire d'un tel dispositif, on projette la scène à travers une optique adaptée sur la matrice de détecteurs élémentaires constituant une « rétine d'imagerie », et des stimuli électriques cadencés sont appliqués par l'intermédiaire du circuit de lecture (également prévu à cet effet), à chacun des détecteurs élémentaires, ou à chaque rangée de tels détecteurs, afin d'obtenir un signal électrique constituant l'image de la température atteinte par chaque détecteur élémentaire. Ce signal est traité de manière plus ou moins élaborée par le circuit de lecture, puis éventuellement par un dispositif électronique extérieur au boîtier, afin de générer une image thermique de la scène observée.

Les performances des détecteurs bolométriques non refroidis dépendent essentiellement :

- de la maîtrise d'élaboration et d'intégration des matériaux bolométriques les plus performants ;
- de la maîtrise des techniques de construction des détecteurs bolométriques ;
- de la qualité de mise en oeuvre des techniques pour la lecture et l'adressage de ces détecteurs et des diverses fonctions de correction qui sont utilisées dans le circuit de lecture et dans d'autres dispositifs annexes ;
- et de la maîtrise des techniques de conditionnement dans un boîtier étanche sous faible pression.

La présente invention est plus particulièrement orientée vers la maîtrise des techniques de constructions des détecteurs bolométriques, et entre autre, vers la qualité des fonctions de lecture et d'adressage des détecteurs bolométrique en résultant. Elle vise en effet à permettre l'obtention de détecteurs bolométriques très performants grâce à une technique de construction avantageuse, et sans avoir à recourir à des artifices complexes et périlleux d'adressage.

L'art antérieur décrit diverses manières de réaliser des détecteurs élémentaires, ou de les adresser.

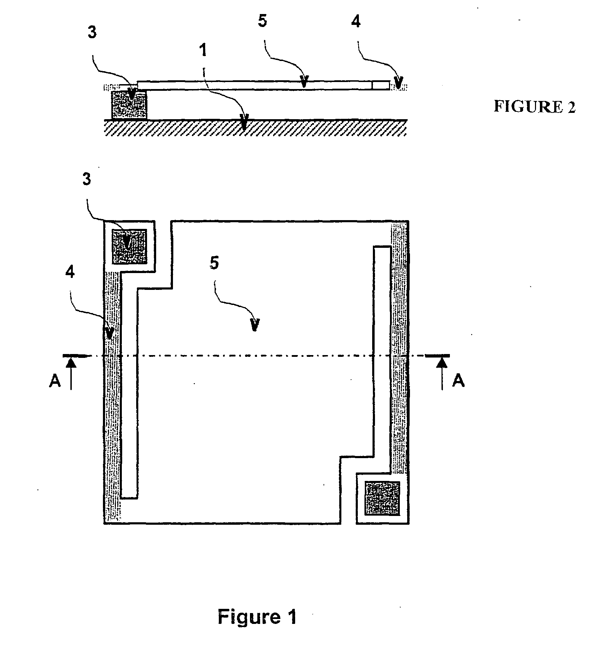

On a illustré en relation avec la figure 1, une représentation schématique d'un détecteur bolométrique de l'art antérieur, dont la figure 2 est une vue en section selon la ligne A-A de la figure 1.

Fondamentalement, ce détecteur comprend une zone active sensible (5), essentiellement constituée d'un matériau bolométrique, c'est à dire d'un matériau sensible, dont la résistivité varie avec la température. Cette zone active (5) est construite sous la forme d'une membrane suspendue au dessus du circuit de lecture (1) au moyen de deux structures (4), de forme allongée.

Chacune des deux structures (4) est conductrice électriquement et reliée au niveau de son extrémité éloignée de la zone active (5) au circuit de lecture (1) au moyen d'une connexion électrique (3) essentiellement verticale, de telle sorte à maintenir la membrane (5) à une distance de l'ordre de 1,5 à 2,5 micromètres au dessus du circuit de lecture, et ce, afin d'optimiser la détection autour de 10 micromètres de longueur d'ondes, correspondant à la plage utile de détection de ce type de détecteur.

Le circuit de lecture (1) est lui-même traditionnellement recouvert d'une couche métallique réfléchissante, destinée à renvoyer le rayonnement infrarouge non absorbé par la membrane (5).

Les structures (4) sont donc conductrices électriquement, mais aussi et de manière fondamentale, résistantes thermiquement. Cette résistance thermique $R_{th}$ dénommée notamment *« isolation thermique »*, est destinée à permettre l'échauffement du matériau bolométrique (5) sous l'effet du rayonnement, notamment infrarouge.

Cette zone (5) comprend un « *thermomètre* » constitué d'une résistance électrique $R_b$ constituée du matériau bolométrique, c'est à dire sensible aux variations de température, mais comprend également des moyens de connecter électriquement les deux pôles électriques de cette résistance aux structures (4), outre des moyens pour absorber le rayonnement infrarouge.

Le matériau bolométrique est habituellement un oxyde de vanadium (Vox) ou du silicium amorphe, ou matériau amorphe voisin, tel que du silicium allié à du germanium et/ou du carbone, cette liste n'étant pas limitative.

Parmi les principaux facteurs de performance d'un microbolomètre, le facteur de remplissage Ff, également dénommé selon l'expression anglo-saxonne *« fill factor »,* est déterminant.

Ce facteur est défini par le rapport de la surface utile sur la surface totale A du microbolomètre. La surface utile peut être considérée comme étant la surface sur laquelle le rayonnement infrarouge est effectivement absorbé, et transmis à la résistance $R_b$. La surface totale A, dans une structure matricielle traditionnelle, constituée de points élémentaires identiques (à une rotation ou à une symétrie près), doit être comprise comme le produit du pas de répétition selon chacun des deux dimensions du plan contenant la matrice : A = [pas en X] . [pas en Y]

Un autre facteur essentiel des performances d'un microbolomètre réside dans la surface Sr selon laquelle s'étend la résistance $R_b$. En effet, cette résistance présente un bruit électrique propre, généralement dominé par le bruit basse fréquence $B_{BF}$ en 1/f, caractéristique en particulier des matériaux bolométriques amorphes. On peut montrer que dans des conditions d'excitation optimales, le rapport signal sur bruit des microbolomètres est proportionnel au facteur $Sr^{1/2}$ au moins pour ce type de matériaux bolométriques.

La performance d'un détecteur bolométrique est traditionnellement exprimée par la résolution thermique NedT (pour l'expression en langue anglaise *« Noise Equivalent Differential Temperature »*) qui se définit par la variation de température produisant un signal équivalent au bruit du détecteur élémentaire. On démontre que la résolution thermique se quantifie par la relation :

$$\frac{1}{NedT} = k \,.\, A \,.\, Ff \,.\, Sr^{1/2} \,.\, R_{th}$$

où k est un paramètre de proportionnalité qui intègre la bande passante du circuit de lecture, le niveau de bruit basse fréquence en 1/f du matériau bolométrique, l'efficacité d'absorption infrarouge des détecteurs élémentaires par unité de surface, et le coefficient de variation relatif de résistance $R_b$ avec la température.

Si par simplification, on admet que la résistance $R_b$ occupe l'essentiel de la surface effective A . Ff, on peut poser $\frac{1}{NedT} = k'.(A.Ff)^{3/2}.R_{th}$ = k'. $(A.Ff)^{3/2}.R_{th}$

Il apparaît donc que les paramètres de l'aire totale A et du facteur de remplissage Ff jouent un rôle essentiel dans l'optimisation du micro-bolomètre, tout particulièrement lorsque l'on cherche à réduire les dimensions de ce dernier, afin d'obtenir des matrices d'imagerie aussi petites que possible.

Ce point est essentiel au niveau du coût de fabrication du détecteur intégré dans le système d'imagerie complet, muni de son optique tel que par exemple dans une caméra.

Il apparaît donc tout particulièrement intéressant de réaliser des micro-bolomètres comportant un nombre réduit de connexions, car ces éléments sont implantés au détriment du facteur Ff.

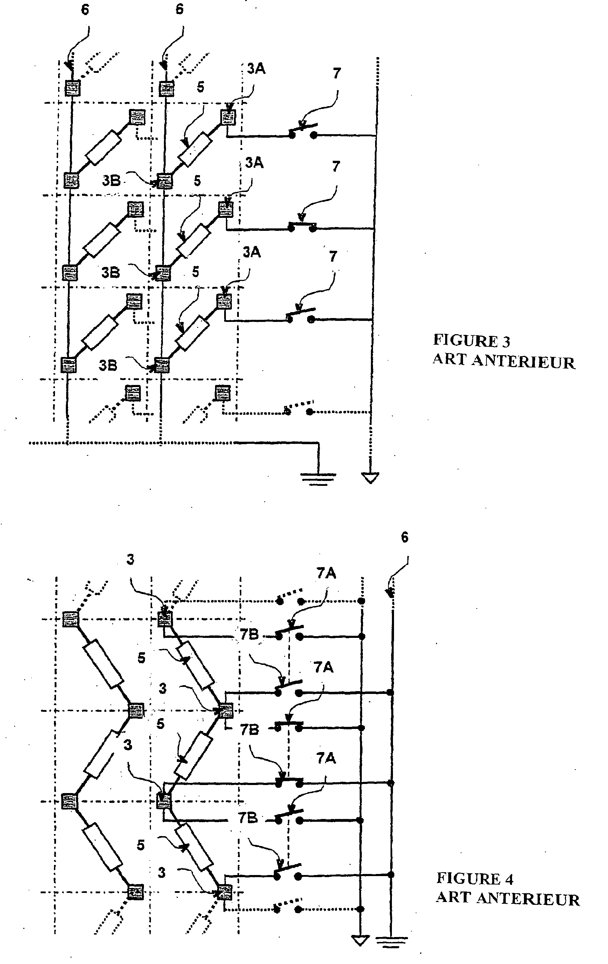

On a représenté en relation avec la figure 3, une partie d'une matrice de microbolomètres traditionnelle, réalisée à l'aide du microbolomètre de la figure 1.

Dans l'exemple illustré, celle-ci est composée de trois lignes et de deux colonnes. Chaque microbolomètre est schématisé par sa zone active (5), et ses connexions, respectivement (3a) et (3b) au circuit de lecture.

Ainsi qu'on peut l'observer sur la figure 3, chaque détecteur bolométrique est relié par l'une de ses connexions (3a) à un interrupteur (7) réalisé au sein du circuit de lecture (1), et par l'autre connexion (3b), directement à une ligne conductrice (6), formée dans le circuit de lecture, et portée à un potentiel essentiellement constant, fourni typiquement par une alimentation de faible impédance. Dans l'exemple représenté, le potentiel de cette ligne (6) a été représenté par le symbole conventionnel de masse électrique. Cette connexion (3b) est pour cette raison communément dénommé point froid. De manière classique, les matrices de détecteurs bolométriques sont lues ligne par ligne, à une fréquence choisie de telle sorte que la durée nécessaire à la lecture de toutes les lignes corresponde au temps trame vidéo, c'est à dire à la durée entre deux images complètes consécutives.

On dispose traditionnellement au bout de chaque colonne un intégrateur de courant, formé dans le circuit de lecture (1), dans lequel on injecte simultanément pour chaque colonne le courant délivré par le détecteur élémentaire correspondant de la ligne en cours de lecture, à travers l'interrupteur (7) fermé par l'activation d'un interrupteur d'adressage ligne (non représenté dans un souci de simplicité).

Cet interrupteur d'adressage a pour effet la fermeture de tous les interrupteurs (7) de la même ligne (dont un seul est représenté sur les différentes figures, correspondant à la colonne de droite).

Ce courant est obtenu par l'application temporaire sur une durée dite temps d'intégration, d'une tension entre les deux connexions de chaque détecteur de la même ligne. Après ce temps d'intégration, les signaux fournis par chaque intégrateur sont transférés en série vers un amplificateur de sortie (également non représenté), pendant que la ligne lue est déconnectée par l'ouverture des interrupteurs (7) provoquée par l'inversion d'état de l'interrupteur d'adressage ligne, et la ligne suivante est adressée par l'activation d'un interrupteur d'adressage de la ligne suivante. Toutes les fonctions sont réalisées à l'aide d'éléments de circuiterie traditionnels en microélectronique.

Corollairement la connexion (3A) de chaque détecteur bolométrique est appelé point chaud, dans la mesure où le courant appliqué par le circuit de lecture est variable dans le temps.

On a décrit, dans un mode de réalisation du document US-A-6 249 002, et notamment dans sa figure 3b, une architecture particulière des connexions des microbolomètres d'une matrice, destinée à limiter le nombre de connexions total de la matrice. Cette forme de réalisation a été schématisée en relation avec la figure 4. Selon les enseignements de ce document, chaque détecteur (5) comporte deux connexions (3) avec le circuit de lecture, chacune de ces connexions étant partagée par un détecteur immédiatement adjacent, en dessus et en dessous dans la même colonne.

Cette disposition particulière permet ainsi de limiter le nombre de connexions à un nombre inférieur à 2n fois le nombre de détecteurs de la matrice, où n représente le nombre total de détecteurs. Dans cette configuration, les détecteurs des première et dernière lignes comportent nécessairement une connexion reliée à un seul détecteur, le nombre de connexions est donc par ailleurs supérieur à n.

Si cette configuration permet de réduire effectivement le nombre de connexions, en revanche, elle exige une configuration complexe du système d'adressage.

Ainsi, afin de connecter un détecteur particulier à l'amplificateur situé en bout de colonne lors de la lecture d'une ligne, il est nécessaire d'isoler tous les autres détecteurs de la même colonne, pour éviter les courants parasites, qui pourraient circuler dans un sens ou dans l'autre à travers les autres détecteurs connectés en série, avec le détecteur en cours de lecture.

A cet effet, chaque connexion est reliée à une paire d'interrupteurs (7A) (7B), réalisés dans le circuit de lecture. Pour assurer la lecture d'un détecteur particulier, et dans l'exemple décrit le détecteur en haut à droite, l'un des deux interrupteurs de chaque paire reliée aux deux connexions de ce détecteur est fermé, grâce à une activation commune (représentée par le segment en traits discontinus), et tous les autres interrupteurs reliés à tous les autres connexions de la même colonne sont ouverts.

Afin d'assurer la lecture de la ligne suivante, située par exemple en-dessous du détecteur précité, les deux interrupteurs précédents sont ouverts, et le couple suivant d'interrupteurs (7A, 7B) est fermé par activation commune. De cette manière, seul le détecteur situé en dessous du détecteur précédent est relié à son tour à l'intégrateur de bout de colonne.

Cette configuration particulière est valide, lorsque tous les signaux sont bien établis en mode statique.

Cependant, la présence permanente de la résistance répartie constituée par la colonne de détecteurs entière, associée à la capacité répartie de cette colonne pose de sérieux problèmes de qualité de la lecture.

La figure 4 montre par exemple que lors de la sélection d'un détecteur quelconque, la connexion froide du détecteur précédent dans la même colonne devient la connexion chaude du détecteur sélectionné, et la connexion chaude du détecteur suivant (sélectionné lors de la trame précédente) devient la connexion froide du détecteur sélectionné.

Il en résulte des courants transitoires parasites de charge et décharge à travers le détecteur en cours de lecture, qui perturbent le signal à la fréquence ordinaire de fonctionnement.

Même à basse fréquence de lecture, la polarisation des détecteurs bolométriques doit s'effectuer préférentiellement en mode pulsé, par essence très sensible aux capacités vues par les points chauds, et de plus, ces capacités sont différentes à proximité des bords supérieur ou inférieur de la matrice.

Il résulte de cette disposition de points chauds comme un lignage de l'image, d'intensité variable d'une ligne à l'autre, selon le numéro d'ordre de chaque ligne dans la matrice.

Ces défauts ne peuvent éventuellement être éliminés qu'au prix d'une complexification supplémentaire conséquente du circuit de lecture, pour maîtriser tous les potentiels à tout instant, et éliminer ou uniformiser l'effet des capacités de points chauds. De la sorte, le bénéfice procuré par le nombre de connexions réduit, est gravement obéré par ce défaut.

## RESUME DE L'INVENTION

L'objet de la présente invention vise un dispositif de détection, visant à réduire le nombre de connexions des détecteurs avec un circuit de lecture associé, sans pour autant produire ce défaut de lignage.

Ce dispositif de détection infrarouge comprend une matrice de détecteurs bolométriques connectés électriquement à un circuit de lecture, dans lequel chacun des détecteurs élémentaires comporte au moins deux structures d'isolation thermique conductrices électriquement isolées l'une de l'autre, et montées en contact au niveau de l'une de leurs extrémités avec une zone active constituée d'un matériau bolométrique, c'est à dire d'un matériau sensible, dont la résistivité varie avec la température, dans lequel :

- l'une desdites structures est reliée électriquement au niveau de son autre extrémité au circuit de lecture au moyen d'une connexion électrique, et portée à un potentiel sensiblement constant ;
- l'autre desdites structures est reliée électriquement au niveau de son autre extrémité au circuit de lecture également au moyen d'une connexion électrique, elle-même reliée en série avec un interrupteur intégré au circuit de lecture.

Il se caractérise en ce qu'au moins deux détecteurs bolométriques adjacents sont connectés par une connexion électrique commune au potentiel sensiblement constant du circuit de lecture.

Ce faisant, en n'affectant plus la connexion chaude de chacun des détecteurs bolométriques, qui demeure de fait individualisée, on ne génère plus le phénomène de lignage généré par les dispositifs de l'art antérieur. Parallèlement, la mise en oeuvre d'au moins une connexion froide commune à deux ou plusieurs détecteurs bolométriques, permet de réduire le nombre de connexions, et corollairement, d'augmenter la surface utile du dispositif de détection en résultant, et partant, son efficacité en termes de détection.

## BREVE DESCRIPTION DES FIGURES

La manière dont l'invention peut être réalisée et les avantages qui en découlent ressortiront mieux des exemples de réalisation qui suivent, donnés à titre indicatif et non limitatif, à l'appui des figures annexées.

Comme déjà dit, la figure 1 est une représentation schématique d'un détecteur bolométrique de l'art antérieur, dont la figure 2 est une vue en section, réalisée au niveau de la ligne A - A dans la figure 1.

La figure 3 est une représentation schématique d'une matrice partielle de détecteurs bolométriques selon une configuration traditionnelle.

La figure 4 est une représentation schématique partielle d'une matrice de détecteurs bolométriques selon les enseignements du document US-A-6 249 002.

La figure 5 est une représentation schématique d'une matrice de détecteurs bolométriques selon une première forme de réalisation de l'invention.

La figure 6 est une représentation schématique d'une matrice de détecteurs bolométriques selon une seconde forme de réalisation de l'invention.

La figure 7 est une représentation schématique détaillée de l'organisation topographique d'une matrice de 3 x 3 détecteurs élémentaires, correspondant à la représentation de la figure 5.

La figure 8 est une représentation schématique détaillée de l'organisation topographique d'une matrice de 3 x 3 détecteurs élémentaires, correspondant à la représentation de la figure 6.

## DESCRIPTION DETAILLEE DE L'INVENTION

Les détecteurs bolométriques ou microbolomètres mis en oeuvre dans le cadre de la présente invention sont de type classique, et sont par exemple du type de celui décrit en relation avec la figure 1.

Ainsi qu'on l'aura compris, l'invention vise fondamentalement une matrice de détecteurs bolométriques, et notamment le mode de connexion desdits détecteurs au niveau du circuit de lecture (1).

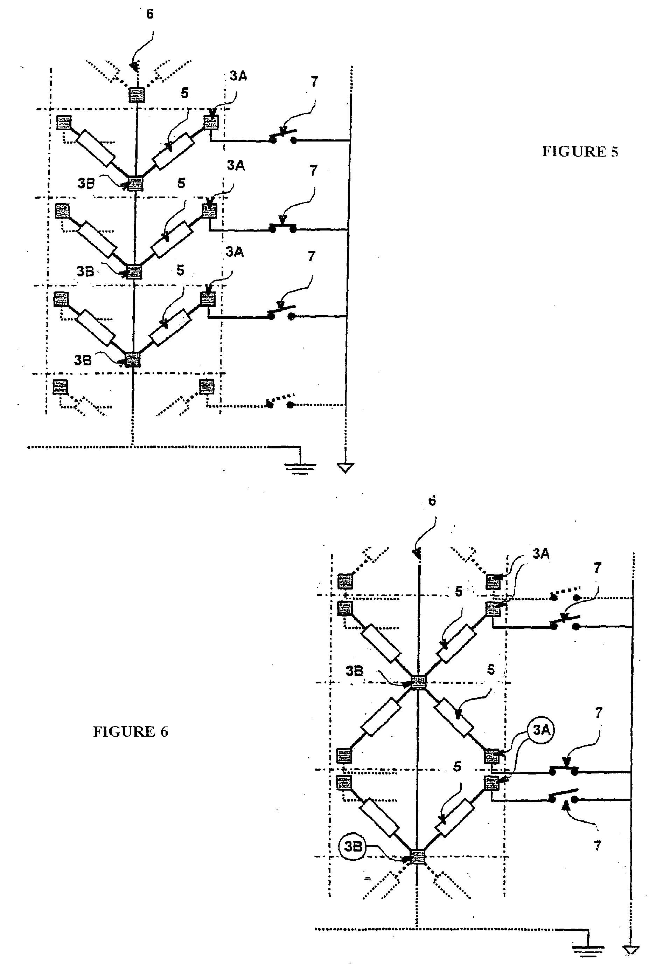

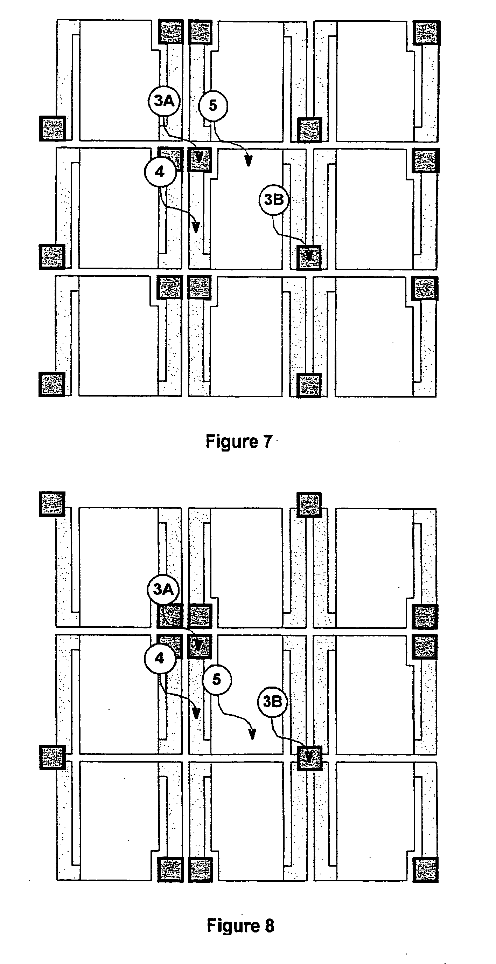

Dans l'exemple décrit en relation avec les figures 5 et 7, il peut être observé que la connexion chaude (3A) de chacun des bolomètres (5), est reliée à un interrupteur (7) du circuit de lecture (1) de manière individuelle. Il est rappelé que cet interrupteur (7) est fermé lors de la lecture du microbolomètre concerné, et en revanche, demeure ouvert le reste du temps.

En revanche, deux bolomètres appartenant à deux colonnes adjacentes et situés sur la même ligne sont reliés au circuit de lecture de manière permanente par une même connexion froide (3B), c'est à dire porté à un potentiel sensiblement constant.

L'ensemble des connexions froides (3B) de deux colonnes adjacentes sont ainsi reliées à une même ligne de courant (6), reliée comme déjà dit à un potentiel sensiblement constant.

Attendu que le potentiel sensiblement constant est commun à tous les microbolomètres d'une même matrice, cette ligne de potentiel froid (6) est identique toutes les deux colonnes.

Dans la forme de réalisation de l'invention représentée en liaison avec les figures 6 et 8, le même principe directeur est appliqué, sauf qu'il concerne cette fois quatre détecteurs microbolométriques appartenant à deux colonnes adjacentes et deux lignes adjacentes. Dans cette configuration, chacun des détecteurs bolométriques est relié au circuit de lecture par une connexion chaude (3A) individuelle, chacune desdites connexions étant elle-même reliée à un seul interrupteur (7). En revanche, ces quatre détecteurs microbolométriques partagent la même connexion froide (3B), elle-même reliée à la ligne de potentiel froid, c'est à dire au potentiel sensiblement constant Là encore, on retrouve une ligne de potentiel froid (6) identique toutes les deux colonnes.

Cette disposition particulière présente l'avantage de diminuer encore de manière supplémentaire le nombre de connexions de la matrice.

Si des formes de réalisation représentées en relation avec les figures 5 et 6, présentent une connexion froide commune pour deux, respectivement quatre détecteurs bolométriques, il doit être bien compris qu'un nombre quelconque, notamment supérieur à quatre microbolomètres peuvent partager la même connexion froide.

La séquence d'adressage d'une telle séquence de microbolomètre repose sur une technique traditionnelle d'ouverture et de fermeture des interrupteurs (7) selon une séquence commandée par une horloge et des interrupteurs dédiés (non représentés) qu'il n'y a pas lieu de détailler ici plus en détail, car bien connu de l'homme du métier.

Il convient de noter que chacun des détecteurs bolométriques est isolé des autres détecteurs d'une même matrice, au niveau de sa connexion chaude, qui elle est individuelle.

Ce faisant, il n'y a aucune pollution du signal individuel par des courants parasites, la connexion chaude de chacun des microbolomètres étant, comme déjà dit, individualisée, et n'est jamais transformée en connexion froide, contrairement à l'art antérieur.

En d'autres termes, il n'y a pas, lors du fonctionnement de la matrice, alternance des fonctions des connexions, notamment successivement connexion chaude et connexion froide, avec les inconvénients déjà mentionnés, et la complexité qu'une telle architecture implique.

A titre exemplatif, sur un espace de 30 x 30 micromètres, la surface nécessaire pour loger une connexion individuelle selon les techniques traditionnelles disponibles est typiquement de l'ordre de 6 x 6 à 8 x 8 micromètres.

Si l'on admet un facteur de remplissage Ff de l'ordre de 70% pour un dispositif de détection à 2n connexions, compte-tenu de l'espace nécessaire pour loger des structures (4) d'isolation thermique, la configuration de l'invention, conforme par exemple à la figure 6, procure une amélioration relative d'espace de l'ordre de 5 à 7%, soit une amélioration de performance de détection de 7 à 11%, tout à fait avantageuse dans le domaine considéré.

Il est en outre possible de concevoir des structures d'isolation plus allongées, induisant une meilleure résistance thermique $R_{th}$ et une plus grande facilité pour construire ou optimiser les fonctions internes au corps principal (5) du microbolomètre. Ce faisant, une amélioration de performances globales de l'ordre de 10 à 15% est observée.

Cet avantage est d'autant plus sensible que les dimensions du détecteur élémentaire sont réduites pour diminuer les dimensions de la matrice.

Cet avantage peut être obtenu par la mise en oeuvre d'un circuit électrique traditionnel sans défaut de lignage, lié aux charges capacitives de type RC le long des colonnes, comme déjà explicité en relation avec la description de l'art antérieur, puisque chaque détecteur élémentaire est lu de manière isolée avec une capacité parasite minimale et constante, d'un détecteur à l'autre ou d'un pixel à l'autre.

On conçoit dès lors tout l'intérêt de la présente invention, tant en termes d'amélioration des performances de détection qu'en termes de réduction de la taille des matrices de tels détecteurs.

## Revendications

1. Dispositif de détection infrarouge comprenant une matrice de détecteurs bolométriques connectés électriquement à un circuit de lecture (1), dans lequel chacun des détecteurs élémentaires comporte au moins deux structures d'isolation thermique conductrices électriquement (4), isolées l'une de l'autre, et montées en contact au niveau de l'une de leurs extrémités avec une zone active (5) constituée d'un matériau bolométrique, c'est à dire d'un matériau sensible, dont la résistivité varie avec la température, dans lequel :

    - l'une desdites structures (4) est reliée électriquement au niveau de son autre extrémité au circuit de lecture (1) au moyen d'une connexion électrique (3B), dite connexion froide, et portée à un potentiel sensiblement constant ;
    - l'autre desdites structures (4) est reliée électriquement au niveau de son autre extrémité au circuit de lecture (1) également au moyen d'une connexion électrique (3A), dite connexion chaude, elle-même reliée en série avec un interrupteur (7) intégré au circuit de lecture ;

    ***caractérisé* en ce qu'**au moins deux détecteurs bolométriques adjacents sont connectés par une connexion électrique commune (3B) au potentiel sensiblement constant du circuit de lecture (1).

2. Dispositif de détection infrarouge selon la revendication 1, ***caractérisé* en ce que** deux détecteurs bolométriques (5) appartenant à deux colonnes adjacentes de la matrice et situés sur la même ligne sont reliés au circuit de lecture (1) par une même connexion froide (3B).

3. Dispositif de détection infrarouge selon la revendication 1, ***caractérisé* en ce que** quatre détecteurs bolométriques (5) appartenant à deux colonnes adjacentes et deux lignes adjacentes de la matrice sont reliés au circuit de lecture (1) par une même connexion froide (3B).

## Claims

1. Infrared detection device comprising a matrix of bolometric detectors electrically connected to a reading circuit (1), in which each of the elementary detectors includes at least two electrically conductive thermal insulation structures (4), which are insulated from one another and are fitted in contact at one of their ends with an active zone (5) consisting of a bolometric material, that is to say a sensitive material whose resistivity varies with the temperature, in which:

    - one of the said structures (4) is electrically connected at its other end to the reading circuit (1) by means of an electrical connection (3B), which is referred to as a cold connection and is kept at a substantially constant potential;
    - the other of the said structures (4) is electrically connected at its other end to the reading circuit (1), also by means of an electrical connection (3A), which is referred to as a hot connection and is itself connected in series with a switch (7) integrated into the reading circuit;

    ***characterized* in that** at least two adjacent bolometric detectors are connected by a common electrical connection (3B) to the substantially constant potential of the reading circuit (1).

2. Infrared detection device according to Claim 1, ***characterized* in that** two bolometric detectors (5) which belong to two adjacent columns of the matrix and lie on the same line are connected to the reading circuit (1) by the same cold connection (3B).

3. Infrared detection device according to Claim 1, ***characterized* in that** four bolometric detectors (5) which belong to two adjacent columns and two adjacent lines of the matrix are connected to the reading circuit (1) by the same cold connection (3B).

## Patentansprüche

1. Infrarot-Detektionsvorrichtung, umfassend eine Matrix aus mit einer Leseschaltung (1) elektrisch verbundenen bolometrischen Detektoren, bei welcher jeder der Elementardetektoren mindestens zwei elektrisch leitende Wärmeisolationsstrukturen (4) aufweist, welche voneinander isoliert sind und im Bereich eines ihrer Enden in Kontakt mit einer aktiven Zone (5) angebracht sind, welche aus einem bolometrischen Material besteht, das heißt aus einem sensitivem Material, dessen spezifischer Widerstand sich mit der Temperatur verändert, bei welcher:

    - eine der genannten Strukturen (4) im Bereich ihres anderen Endes mit der Leseschaltung (1) mittels eines elektrischen Anschlusses (3B), kalter Anschluss genannt, elektrisch verbunden ist und auf ein im Wesentlichen konstantes Potential gebracht ist;
    - die andere der genannten Strukturen (4) im Bereich ihres anderen Endes mit der Leseschaltung (1) ebenfalls mittels eines elektrischen Anschlusses (3A), warmer Anschluss genannt, elektrisch verbunden ist, welcher seinerseits in Serie mit einem in die Leseschaltung eingebauten Schalter (7) verbunden ist;

    **dadurch *gekennzeichnet*, dass** mindestens zwei einander benachbarte bolometrische Detektoren durch einen gemeinsamen elektrischen Anschluss (3B) mit dem im Wesentlichen konstanten Potential der Leseschaltung (1) verbunden sind.

2. Infrarot-Detektionsvorrichtung nach Anspruch 1, **dadurch *gekennzeichnet*, dass** zwei zu zwei einander benachbarten Spalten der Matrix gehörige und in derselben Reihe befindliche bolometrische Detektoren (5) durch ein und denselben kalten Anschluss (3B) mit der Leseschaltung (1) verbunden sind.

3. Infrarot-Detektionsvorrichtung nach Anspruch 1, **dadurch *gekennzeichnet*, dass** vier zu zwei einander benachbarten Spalten und zwei einander benachbarten Reihen der Matrix gehörige bolometrische Detektoren (5) durch ein und denselben kalten Anschluss (3B) mit der Leseschaltung (1) verbunden sind.

3
1
5
4
FIGURE 2
3
4
5
A
A

Figure 1

6
6
3A
7
5
3B
3A
7
5
3B
3A
7
5
3B

FIGURE 3
ART ANTERIEUR

6
3
7A
7B
5
7A
3
5
7B
3
7A
7B
5
3

FIGURE 4
ART ANTERIEUR

6
3A
7
5
3B
FIGURE 5
FIGURE 6

3A
5
4
3B

Figure 7

3A
4
5
3B

Figure 8

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

### Documents brevets cités dans la description


- US 6064066 A
- US 6249002 A